# EUROPÄISCHE PATENTSCHRIFT

(11) **EP 3 066 902 B1**
(45) Veröffentlichungstag und Bekanntmachung des Hinweises auf die Patenterteilung: **03.04.2019**
(21) Anmeldenummer: 14793099.4
(22) Anmeldetag: 03.11.2014
(51) Int. Cl.: H05K 7/14

(54) **FUNKTIONSKOMPONENTENOBERTEIL FÜR EIN KOMPONENTENAUFBAUSYSTEM**
FUNCTION COMPONENT UPPER PART FOR A COMPONENT CONSTRUCTION SYSTEM
PARTIE SUPÉRIEURE DE COMPOSANT FONCTIONNEL POUR UN SYSTÈME D'ASSEMBLAGE DE COMPOSANTS

(30) Priorität: 04.11.2013 DE 102013112110
(43) Veröffentlichungstag der Anmeldung: 14.09.2016
(73) Patentinhaber: Phoenix Contact GmbH & Co. KG, 32825 Blomberg (DE)
(72) Erfinder: BURY, Joachim, 31812 Bad Pyrmont (DE); SALOMON, Thomas, 33415 Verl (DE)
(74) Vertreter: Patentship Patentanwaltsgesellschaft mbH
(86) Internationale Anmeldenummer: PCT/EP2014/073549
(87) Internationale Veröffentlichungsnummer: WO 2015/063292

(56) Entgegenhaltungen:
- EP-A2- 1 079 465
- WO-A1-02/23676
- DE-C1- 19 616 516
- DE-U1- 29 607 525
- JP-A- 2002 372 152
- JP-A- 2002 372 152
- US-A1- 2005 186 857
- US-A1- 2006 086 521
- US-A1- 2011 011 641

## Beschreibung

Die vorliegende Erfindung betrifft ein Funktionskomponentenoberteil zum Aufsetzen auf ein Funktionskomponentenunterteil einer Funktionskomponente eines Feldbussystems.

Moderne Komponentenaufbausysteme der Automatisierungstechnik bestehen typischerweise aus einer Vielzahl von Funktionskomponenten, die in einem Schaltschrank angeordnet sind. Die Verteilerfunktionen für Energie und Daten sind mit getrennten Stecksystemen realisiert. Ein schaltschrankloser Aufbau ist nicht möglich, da Peripheriegeräte nahe dem Schaltschrank mit einer sternförmigen Energieverteilung hängen. Werden Feldbuskonzepte verwendet, bei denen einzelne Komponenten auf Rückplatten aufgesetzt werden, werden auf die Rückplatten hohe Gewichtskräfte ausgeübt. Gehäuse für Elektrogeräte sind in der Regel einteilig oder zweiteilig. Eine Kombination mit weiteren Gehäusen erfolgt über Verdrahtung oder Schnittstellen in einer Ausbaurichtung.

In der US 2005/186857 A1 ist ein abnehmbares Modul mit einem Gehäuse offenbart, wobei das Modul auf eine Basisanordnung mit einer Rückplatte aufgesetzt werden kann.

In der DE 196 16 516 C1 ist ein Trennadapter offenbart, auf welchem ein Elektronikmodul angeordnet ist, wobei das Elektronikmodul mit dem Trennadapter an Verrastungskonturen mechanisch und an Steckkontakten elektrisch mit dem Trennadapter verbunden ist.

Die Merkmale des Oberbegriffs von Anspruch 1 sind in Dokument WO 02/23676 offenbart.

Es ist die der Erfindung zugrundeliegende Aufgabe, ein Funktionskomponentenoberteil für ein Feldbussystem anzugeben, das in zumindest zwei Dimensionen beliebig erweiterbar ist.

Diese Aufgabe wird durch den Gegenstand mit den Merkmalen nach dem unabhängigen Anspruch gelöst. Vorteilhafte Ausführungsformen der Erfindung sind Gegenstand der Figuren, der Beschreibung und der abhängigen Ansprüche.

Gemäß einem Aspekt der Erfindung wird die Aufgabe durch Funktionskomponentenoberteil zum Aufsetzen auf ein Funktionskomponentenunterteil einer Funktionskomponente eines Komponentenaufbausystems, mit einem Gehäuse; einer in dem Gehäuse gebildeten mechanischen Schnittstelle zum mechanischen Verbinden mit dem Funktionskomponentenunterteil; und Buchsenaufnahmen für die Aufnahme der Stecker des Funktionskomponentenunterteils, welche an einer Unterseite des Gehäuses des Funktionskomponentenoberteils angeordnet sind. Die Buchsenaufnahmen können hervorstehend sein.

Die Schnittstelle kann ferner elektro-mechanisch sein. Die Funktionskomponente kann eine Funktionskomponente eines Komponentenaufbausystems, das ein Feldbussystem sein kann, sein.

In einer vorteilhaften Ausführungsform des Funktionskomponentenoberteils weist die mechanische Schnittstelle an den Ecken des Gehäuses befindliche Schraubverbindungen auf.

In einer weiteren vorteilhaften Ausführungsform des Funktionskomponentenoberteils umfasst das Gehäuse eine umlaufende Dichtkontur für ein Dichtelement, um das Funktionskomponentenoberteil gegenüber dem Funktionskomponentenunterteil oder dem Gehäuseoberteil abzudichten.

In einer weiteren vorteilhaften Ausführungsform des Funktionskomponentenoberteils umfasst das Gehäuse eine Seitenöffnung zum Einführen einer elektrischen Leitung.

In einer weiteren vorteilhaften Ausführungsform des Funktionskomponentenoberteils umfasst das Gehäuse zumindest eine Sechskantaussparung und/oder eine Zylinderaussparung zum Einsetzen eines Abschnittes des Dichtelements.

In einer weiteren vorteilhaften Ausführungsform des Funktionskomponentenoberteils umfasst das Gehäuse an einer Seite eine Sechskantaussparung zum Einsetzen eines Sechskantabschnittes des Dichtelements und an einer gegenüberliegenden Seite eine Zylinderaussparung zum Einsetzen eines Zylinderabschnittes des Dichtelements.

In einer weiteren vorteilhaften Ausführungsform des Funktionskomponentenoberteils umfasst das Gehäuse ein Innengewinde für eine Leitungsverschraubung.

In einer weiteren vorteilhaften Ausführungsform des Funktionskomponentenoberteils umfasst das Funktionskomponentenoberteil eine Anschlussvorrichtung, insbesondere einen Anschlussklemmenblock, zum Anschließen einer eingeführten elektrischen Leitung.

In einer weiteren vorteilhaften Ausführungsform des Funktionskomponentenoberteils umfasst die Anschlussvorrichtung zumindest eine Mantelklemme.

In einer weiteren vorteilhaften Ausführungsform des Funktionskomponentenoberteils umfasst das Funktionskomponentenoberteil einen Deckel mit einer verschließbaren Öffnung.

In einer weiteren vorteilhaften Ausführungsform des Funktionskomponentenoberteils umfasst das Funktionskomponentenoberteil oder der Deckel Kühlrippen zum Ableiten von Wärme, In einer weiteren vorteilhaften Ausführungsform des Funktionskomponentenoberteils ist das Funktionskomponentenoberteil aus einem metallischen Material, aus Kunststoff oder aus Verbundwerkstoffen gebildet.

In einer weiteren vorteilhaften Ausführungsform des Funktionskomponentenoberteils umfasst das Funktionskomponentenoberteil einen Schalter zum Unterbrechen einer elektrischen Leitung und/oder ein Netzteil und/oder einen Frequenzumrichter und/oder ein Display.

In einer weiteren vorteilhaften Ausführungsform des Funktionskomponentenoberteils umfasst das Funktionskomponentenoberteil einen Schalterdurchbruch für einen Anschluss.

In einer weiteren vorteilhaften Ausführungsform des Funktionskomponentenoberteils umfasst das Funktionskomponentenoberteil eine Steckbuchse zum Anschließen einer elektrischen Leitung.

In einer weiteren vorteilhaften Ausführungsform des Funktionskomponentenoberteils umfasst das Funktionskomponentenoberteil eine weitere mechanische Schnittstelle, auf welche ein Funktionsoberteil einer weiteren Funktionskomponente aufsetzbar ist. Auf diese Weise kann das Funktionsoberteil als Zwischenring für die vertikale Erweiterbarkeit mit weiteren Funktionskomponentenoberteilen eingesetzt werden.

Das weitere Funktionsoberteil kann Merkmale des Funktionsoberteils aufweisen.

Die weitere mechanische Schnittstelle kann wie die mechanische Schnittstelle aufgebaut sein und deren Merkmale aufweisen.

Weitere Ausführungsbeispiele der Erfindung sind in den Zeichnungen dargestellt und werden im Folgenden näher beschrieben.

Es zeigen:
- Fig. 1: eine Explosionsansicht eines Feldbussystems;
- Fig. 2: eine Explosionsansicht eines Feldbussystems mit einem Funktionskomponentenoberteil;
- Fig. 3: mehrere Ansichten des Funktionskomponentenoberteils mit aufgesetztem Gehäuseoberteil;
- Fig. 4: eine Ansicht eines Gehäuses des Funktionskomponentenoberteils; und
- Fig. 5: eine Ansicht eines Funktionskomponentenoberteils.

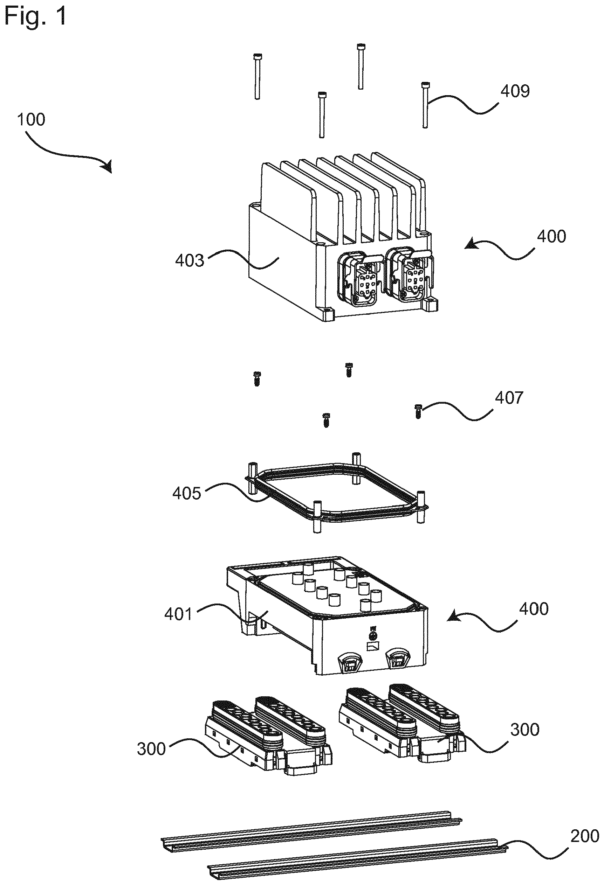

Fig. 1 zeigt eine Explosionsansicht eines Feldbussystems 100. Das Feldbussystem 100 ist gemäß einer Ausführungsform aus einem zusammensteckbaren Gehäusebaukasten zusammengesetzt, bei dem die Komponenten auf eine Tragprofilschiene 200 aufgerastet werden. Das Aufbaukonzept des Feldbussystems 100 umfasst eine Tragprofilschiene 200 als Montageplattform, Brückenmodule 300 und Funktionskomponenten 400, die jeweils aus einem Funktionskomponentenunterteil 401 als Verbindungsunterteil und einem Gehäuseoberteil 403 als Funktionsoberteil bestehen. Zwischen dem Funktionskomponentenunterteil 401 und dem Gehäuseoberteil 403 ist ein Dichtelement 405 angeordnet, um ein Eindringen von Feuchtigkeit zu verhindern. Das Dichtelement 405 wird mittels Schrauben 407 an dem Funktionskomponentenunterteil 401 befestigt. Das Gehäuseoberteil 403 wird ebenfalls mittels Schrauben 409 auf das Funktionskomponentenunterteil 401 aufgeschraubt.

Je nach Anwendungszweck können unterschiedliche Ausführungen des Aufbaukonzeptes realisiert werden. Das Aufbaukonzept ist endlos erweiterbar. Die internen elektrischen Verbindungen für Energieverteilung von beispielsweise 400V oder 24V und der Datenbus werden gleichzeitig mit dem Zusammenstecken der Komponenten realisiert. Die Verbindungsfunktionen werden in einem Funktionskomponentenunterteil 401 der Funktionskomponenten 400 und den Brückenmodulen 300 mit den Brückensteckern 305 realisiert. Die Funktionen Versorgen, Schützen, Schalten ergeben sich aus der Reihenfolge der Anordnung der Funktionskomponenten 400. Die Anwenderfunktionen, wie beispielsweise Versorgen, Schützen oder Schalten, sind im Gehäuseoberteil 403 realisiert, das über Steckkontakte mit dem Funktionskomponentenunterteil 401 verbunden ist.

Das Gehäuseoberteil 403 als Funktionsmodul hat eine definierte mechanische und optional eine elektrische Schnittstelle zum Funktionskomponentenunterteil 401 und kann auch auf anderen Funktionskomponentenunterteilen 401 mit gleicher Schnittstelle verwendet werden. Das Funktionskomponentenunterteil 401 enthält die Verbindungstechnik. Das Gehäuseoberteil 403 enthält beispielsweise die Funktionen Trennen, Schützen oder Schalten. Die Wirkungsrichtung der vorgenannten Funktionen erfolgt je nach Gehäuseoberteil 403 und Funktionskomponentenunterteil 401 in der Linie und/oder in den Verbraucherabgang, d.h. einer Steckverbindung in das Gehäuseoberteil 403. Die Verbindungstechnik kann im Funktionskomponentenunterteil 401 unterbrochen sein.

Die Tragprofilschiene 200 bildet ein einteiliges Trägersystem mit einer breiten Schiene für einen Rack-Aufbau, die die Geometrie der Auflagekanten des Brückenmoduls 300 und der Funktionskomponenten 400 nachbildet. Alternativ können zwei getrennte Standard-Tragprofilschienen als zweiteiliges Trägersystem, beispielsweise mit einer Breite von 35 mm, für einen Wandaufbau verwendet werden. Das Tragprofil kann durch ein Hutprofil gebildet werden.

Das Brückenmodul 300 ist das Schlüsselverbindungselement im Gehäuseaufbaukonzept des Feldbussystems 100, welches sowohl die elektrischen Verbindungen zwischen den Funktionskomponenten 400 übernimmt, als auch zusammen mit der Tragprofilschiene 200 die Verbindung zur klassischen Aufbautechnik bildet. Im Allgemeinen kann das Brückenmodul 300 als Loslager ausgebildet sein, dass lediglich rastend und verschiebbar an der Tragprofilschiene 200 befestigt ist oder als ein Festlager mit metallischer Klemmvorrichtung und PE-Kontaktierung.

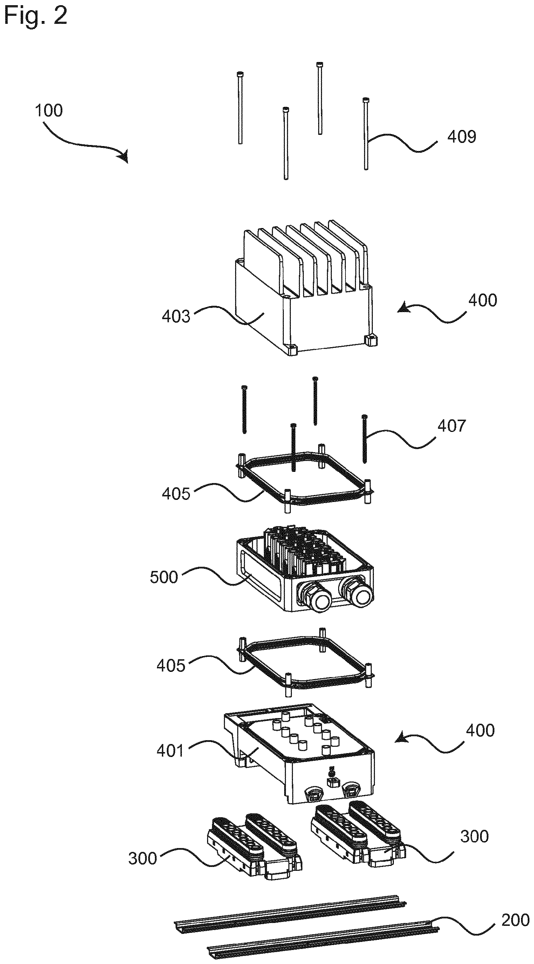

Fig. 2 zeigt eine Explosionsansicht eines Feldbussystems 100 mit einem Funktionskomponentenoberteil 500. Das Funktionsmodul 403 mit einer Netzgerätefunktion wird mit einem Dichtelement 405 auf das Funktionskomponentenoberteil 500 aufgesetzt und dabei elektrisch und mechanisch verbunden. Das Funktionskomponentenoberteil 500 wird auf das Funktionskomponentenunterteil 401 aufgesetzt und weist eine Verteilerfunktion auf.

Das Funktionskomponentenoberteil 500 ist zwischen dem Gehäuseoberteil 403 und dem Funktionskomponentenunterteil 401 angeordnet. Durch das Funktionskomponentenoberteil 500 wird ein Gehäusemittelteil als Zwischenring mit elektrischer Anschlusseinheit gebildet. Auf diese Weise lassen sich die gleichen mechanischen und elektrischen Schnittstellen nach oben und unten stapeln. Beim Aus- oder Anbau des Feldbussystems existiert eine einzige Fügerichtung für alle Kombinationen und nur eine elektrische Anschlusseinheit für einen verdrahteten Anschluss oder eine Stecklösung.

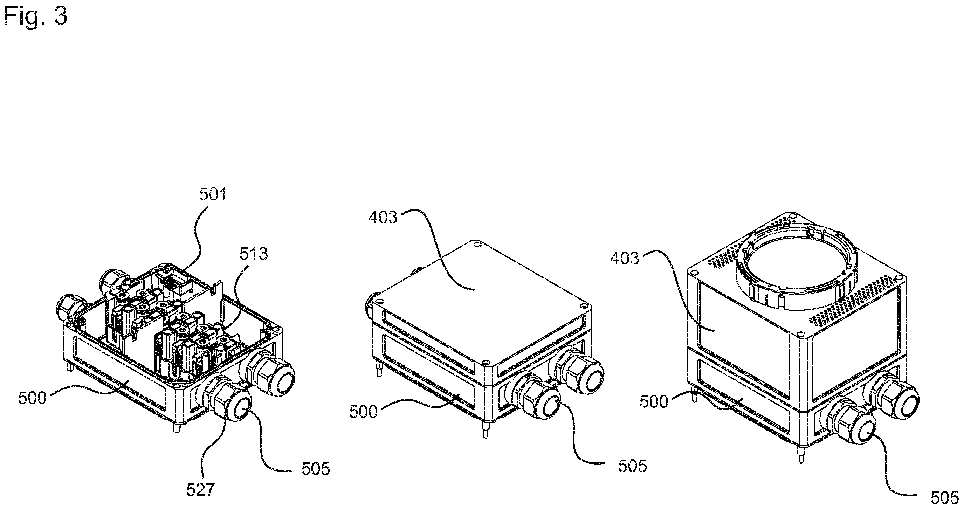

Fig. 3 zeigt mehrere Ansichten des Funktionskomponentenoberteils 500 mit aufgesetztem Gehäuseoberteil 403 der Funktionskomponente 400. Das Funktionskomponentenoberteil 5001 umfasst ein Gehäuse 501, das eine Anschlussvorrichtung 513 seitlich umgibt und an der Oberseite und der Unterseite offen ist. In der Seitenwand des Gehäuses 501 ist eine Öffnung 505 mit einer Dichtschraube 527 angeordnet, um ein Kabel von außen zu der Anschlussvorrichtung 513 zuführen zu können. Auf das Funktionskomponentenoberteil 500 sind modular unterschiedliche Gehäuseoberteile 403 aufsetzbar, wie beispielsweise ein Gehäuseoberteil 403 mit Netzgerätefunktion oder Deckelfunktion.

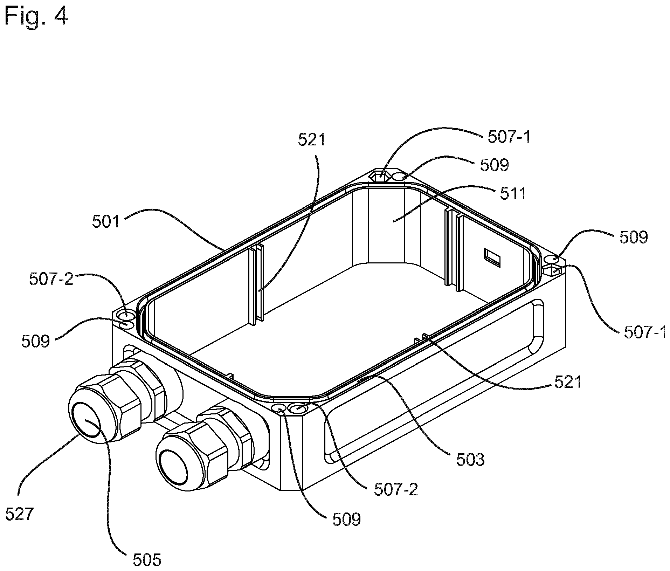

Fig. 4 zeigt eine Ansicht eines Gehäuses 501 des Funktionskomponentenoberteils 500. Das Gehäuse 501 umfasst eine umlaufende Aussparung 503 zum Einsetzen eines Dichtelements 405, um das Funktionskomponentenoberteil 500 gegenüber dem Funktionskomponentenunterteil 401 oder dem Gehäuseoberteil 403 abzudichten. Die umlaufende Aussparung 503 bildet dadurch eine Dichtkonturnut für das Dichtelement 405. In der Seitenwand des Gehäuses 501 sind zwei Seitenöffnungen 505 mit jeweils einer Dichtschraube 527 zum Einführen eines Kabels 515 gebildet.

An der Oberseite und der Interseite des Gehäuses 501 sind jeweils zwei Sechskantaussparungen 507-1 und zwei Zylinderaussparungen 507-2 zum Einsetzen eines entsprechenden Abschnittes des Dichtelements 405 gebildet. Eine Führung und Kodierung erfolgt beim positionsrichtigen Zusammenfügen der Gehäuseteile durch die beidseitigen Sechskantaussparungen 507-1 und zwei Zylinderaussparungen 507-2 die als Führungshülsen im Inneren des Gehäuses 501 wirken.

Das Gehäuse 501 weist einen Eckbereich 511 mit einer größeren Wandstärke als im Seitenbereich des Gehäuses 501 auf und wird durch den Eckbereich 511 diagonal verstärkt. Daneben sind in dem diagonal verstärkten Eckbereich 511 die jeweiligen Sechskantaussparungen 507-1 oder Zylinderaussparungen 507-2 gebildet. Daneben umfasst das Gehäuse 501 in dem jeweiligen Eckbereich 511 ein Innengewinde 509 zum Aufschrauben des Dichtelements 405 mittels einer Schraube.

An der Innenseite des Gehäuses 501 sind zwei gegenüberliegende Führungsnuten 521 zum Führen einer Stützplatte oder Trennwand vorgesehen. Die einsetzbare Stützplatte zum Abstützen der Anschlussvorrichtung 513 an dem Gehäuse 501. Das Funktionskomponentenoberteil 500 umfasst in diesem Fall eine einsetzbare Trennwand.

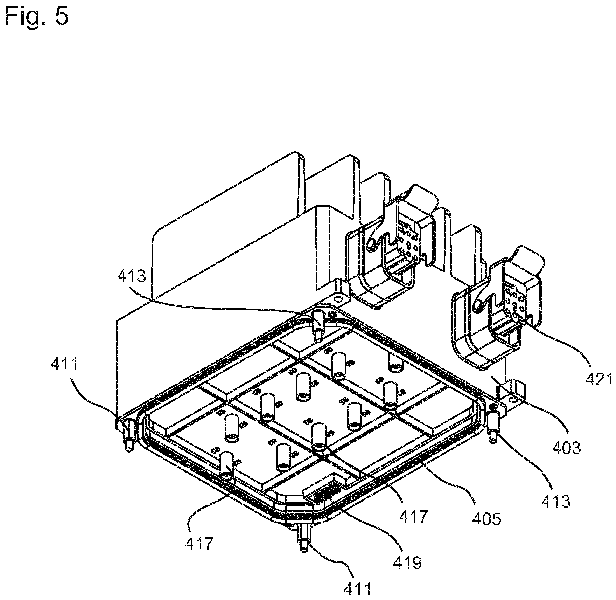

Fig. 5 zeigt eine Ansicht des Funktionskomponentenoberteils 403. An der Unterseite des Funktionskomponentenoberteils 403 befinden sich Steckkontakte 417 als Schnittstelle zum Herstellen einer Verbindung mit dem Funktionskomponentenoberteil 500. Daneben umfasst die Unterseite des Funktionskomponentenoberteils 403 eine Datenbusschnittstelle 419, die beim Aufsetzen des Funktionskomponentenoberteils 403 mit dem Funktionskomponentenoberteil 500 verbunden wird. Zusätzlich ist an der Unterseite des Funktionskomponentenoberteils 403 das Dichtelement 405 mit den Sechskantabschnitten 411 und den Zylinderabschnitten 413 aufgesetzt, die in die jeweiligen Sechskantaussparungen 507-1 und Zylinderaussparung 507-2 eingesetzt werden. Seitlich an dem Funktionskomponentenoberteil 403 sind weitere Steckkontakte 421 zum Anschließen von Kabeln angeordnet.

Daneben kann das Funktionskomponentenoberteil 403 ein oder mehrere verschließbare Öffnungen zum Anschließen eines Kabels, Luken, Schalterdurchbrüche für Anschlüsse, Steckbuchsen, Schalter oder Kühlrippen umfassen. Das Gehäuse des Funktionskomponentenoberteils 500 kann aua einem metallischen Material, aus Kunststoff oder Verbundwerkstoff hergestellt sein.

Insbesondere kann das Funktionskomponentenoberteil 403 zusätzlich zu der Schnittstelle zu einem darunter angeordneten Funktionskomponentenunterteil als auch eine zweite mechanische oder elektromechanische Schnittstelle zu einem darüber angeordneten, weiteren Funktionskomponentenoberteil 403 umfassen. In diesem Fall kann das Funktionskomponentenoberteil 403 als Zwischenteil bzw. als ein Zwischenring für die vertikale Erweiterbarkeit verwendet werden. Das Gehäuse 501 kann in diesem Fall rahmenförmig sein.

Die Feldstationen können durch Verwendung einer einfachen Einspeisung als Endgeräte einer klassischen Sternverteilung genutzt werden oder durch Verwendung eines Anschluss- und Verteilermoduls (AV-Modul) zu Teilnehmern oder Knoten eines Energieverteilungsnetzwerks werden. Schalt- und Schutzorgane, Motorschalter, Buskoppler, oder I/Os, usw. können in freier, funktionsbestimmter Reihenfolge links und rechts des AV-Moduls angeordnet werden. Dadurch werden Vorteile beim Engineering durch eine sichtbare Trennung von Klein- und Niederspannungskomponenten erreicht. Mehrere Feldstationen können als Teilnehmer ein Netzwerk in beliebiger Struktur, wie beispielsweise Linie, Baum oder Ring, aufspannen.

Ein zentraler Schaltschrank innerhalb des ausgelegten Leistungsbereichs der Energieverteilung ist nicht mehr erforderlich. Durch eine geeignete Ausführung des mitgeführten Datenbusses können die Reihenfolge und die Positionen einzelner Komponenten der Feldstation vor der Inbetriebnahme auf die planungsgerechte Anordnung überprüft werden (Remote Putting into Service, Remote Service).

Das Feldbussystem 100 ermöglicht einen Aufbau von 'smarten' Installationsnetzwerken für Gleichstrom und Wechselstrom und schaltschranklose Verteilungen in geeigneten Anlagenlayouts. Das Feldbussystem kann in den Anwendungsgebieten Installation oder Energieverteilung verwendet werden. Bei einer verteilten Automatisierung ist ein Aufbau von modularen Feldstationen als Funktionsknoten in 'smarten' Installationsnetzwerken möglich. In alternativen Schaltschrank-Konzepten ist ein Aufbau von modularen Stationen im Schaltschrank ohne Stromschienen und ohne Steuerverdrahtung mit identischer Projektierung für IP20... IP6x möglich.

Durch das Feldbussystem 100 können modulare Motorschalter im Feld mit hoher Schutzart entwickelt werden. Durch das Feldbussystem 100 wird zusätzlich ein ganzheitliches Aufbaukonzept (Power & Drive, P&D) entwickelt, das die Aufgabe einer vorteilhaften Verteilung und Bereitstellung von Energie im Feld löst, beispielsweise außerhalb eines Schaltschranks. Die Modularität des Feldbussystems 100 ermöglicht die Ausweitung der Anwendung über die modulare Feldstation hinaus zur 'smarten' Energieverteilung bis hin zu einem alternativen Schaltschrankaufbau. Zudem kann eine Abdeckung des Spektrums von Stand-Alone-Funktionskomponenten als Endgeräte an einer klassisch sternförmigen Energieverteilung erreicht werden. Das Feldbussystem 100 ermöglicht einen flexiblen Aufbau von modularen Systemen im Feld (IP6x) und innerhalb oder außerhalb eines Schaltschranks auf Standard-Tragprofilschienen (IP20). Bei einer Vormontage kann eine Vorverdrahtung auf einem Montagegestell erfolgen.

Das vorgenannte Feldbussystem 100 realisiert einen Gehäusebaukasten, der die notwendige Flexibilität für einen modularen Aufbau ermöglicht und damit die Grundlage für ein dezentrales Installationssystem oder ein dezentrales Automatisierungssystem liefert. Durch die Erweiterung der Montagemöglichkeit auf Tragschienen kann das Aufbaukonzept auch innerhalb von Schaltschränken eingesetzt werden. Dadurch ergibt sich ein Gehäusekonzept für Funktionskomponenten, wie beispielsweise Netzteile, Motorschalter mit variabler Aufbautechnik. Im Allgemeinen kann das Feldbussystem 100 für eine Wandmontage oder Tragschienenmontage mit elektrischer Anschlusseinheit ausgebildet sein. Das Feldbussystem 100 umfasst eine variable Anschlusstechnik zum Anschluss über Leitungen oder über ein Gehäuse-integriertes Stecksystem.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Feldbussystem

- 200: Tragprofilschiene

- 300: Brückenmodul

- 400: Funktionskomponente
- 401: Funktionskomponentenunterteil
- 403: Funktionskomponentenoberteil
- 405: Dichtelement
- 407: Schrauben
- 409: Schrauben
- 411: Sechskantabschnitt
- 413: Zylinderabschnitt
- 417: Steckkontakte
- 419: Datenbusschnittstelle
- 421: Steckkontakte

- 500: Funktionskomponentenoberteil
- 501: Gehäuse
- 503: Aussparung
- 505: Seitenöffnung
- 507-1: Sechskantaussparung
- 507-2: Zylinderaussparung
- 509: Innengewinde
- 511: Innengewinde
- 513: Anschlussvorrichtung
- 515: Kabel
- 517: Mantelklemme
- 519: Stützplatte
- 521: Führungsnut
- 523: Befestigungslasche
- 525: Aussparung
- 527: Dichtschraube

## Patentansprüche

1. Funktionskomponentenoberteil (403, 500) zum Aufsetzen auf ein Funktionskomponentenunterteil (401) einer Funktionskomponente (400) eines Komponentenaufbausystems (100), mit:
einem Gehäuse (501);
einer in dem Gehäuse (501) gebildeten mechanischen Schnittstelle zum mechanischen Verbinden mit dem Funktionskomponentenunterteil (401); und
Buchsenaufnahmen für die Aufnahme der Stecker des Funktionskomponentenunterteils (401), welche an einer Unterseite des Gehäuses (501) des Funktionskomponentenoberteils (500) angeordnet sind,
wobei das Funktionskomponentenoberteil (500) eine Anschlussvorrichtung (513), insbesondere einen Anschlussklemmenblock, zum Anschließen einer eingeführten elektrischen Leitung (515) umfasst, und
**dadurch gekennzeichnet, dass** das Gehäuse (501) eine umlaufende Dichtkontur (503) für ein Dichtelement (405) umfasst, um das Funktionskomponentenoberteil (500) gegenüber dem Funktionskomponentenunterteil (401) oder einem Gehäuseoberteil (403) abzudichten, wobei das Gehäuse (501) zumindest eine Sechskantaussparung (507-1) und eine Zylinderaussparung (507-2) umfasst, und wobei das Gehäuse (501) an einer Seite eine Sechskantaussparung (507-1) zum Einsetzen eines Sechskantabschnittes des Dichtelements (405) und an einer gegenüberliegenden Seite eine Zylinderaussparung (507-2) zum Einsetzen eines Zylinderabschnitts des Dichtelements (405) umfasst.

2. Funktionskomponentenoberteil (500) nach Anspruch 1, wobei die mechanische Schnittstelle an den Ecken des Gehäuses befindliche Schraubverbindungen aufweist.

3. Funktionskomponentenoberteil (500) nach Anspruch 1 oder 2, wobei das Gehäuse (501) eine Seitenöffnung (505) zum Einführen einer elektrischen Leitung (515) umfasst.

4. Funktionskomponentenoberteil (500) nach einem der Ansprüche 1 bis 3, wobei das Gehäuse (501) ein Innengewinde (509) für eine Leitungsverschraubung umfasst.

5. Funktionskomponentenoberteil (500) nach einem der Ansprüche 1 bis 4, wobei die Anschlussvorrichtung (513) zumindest eine Mantelklemme (517) umfasst.

6. Funktionskomponentenoberteil (500) nach einem der vorangehenden Ansprüche, wobei das Funktionskomponentenoberteil (500) einen Deckel mit einer verschließbaren Öffnung umfasst oder bildet.

7. Funktionskomponentenoberteil (500) nach einem der vorangehenden Ansprüche, wobei das Funktionskomponentenoberteil (500) Kühlrippen zum Ableiten von Wärme umfasst.

8. Funktionskomponentenoberteil (500) nach einem der vorangehenden Ansprüche, wobei das Funktionskomponentenoberteil (500) aus einem metallischen Material, aus Kunststoff oder aus einem Verbundwerkstoff gebildet ist.

9. Funktionskomponentenoberteil (500) nach einem der vorangehenden Ansprüche, wobei das Funktionskomponentenoberteil (500) einen Schalter zum Unterbrechen einer elektrischen Leitung oder ein Netzteil oder einen Frequenzumrichter oder ein Display umfasst.

10. Funktionskomponentenoberteil (500) nach einem der Ansprüche, wobei das Funktionskomponentenoberteil (500) eine Steckbuchse zum Anschließen einer elektrischen Leitung oder einen Schalterdurchbruch für einen elektrischen Anschluss umfasst.

11. Funktionskomponentenoberteil (500) nach einem der Ansprüche, wobei das Funktionskomponentenoberteil (500) eine weitere mechanische Schnittstelle umfasst, auf welche ein Funktionsoberteil einer weiteren Funktionskomponente aufsetzbar ist.

## Claims

1. Functional component upper part (403, 500) for placing onto a functional component lower part (401) of a functional component (400) of a component assembly system (100), comprising
a housing (501);
a mechanical interface formed in the housing (501) for mechanical connection to the functional component lower part (401); and
socket-type receptacles for receiving the connectors of the functional component lower part (401), said socket-type receptacles being arranged on an underside of the housing (501) of the functional component upper part (500),
wherein the functional component upper part (500) comprises a connection device (513), in particular a terminal block, for connecting an inserted electrical cable (515), and **characterized in that**
the housing (501) comprises a circumferential sealing contour (503) for a sealing element (405) for sealing the functional component upper part (500) with respect to the functional component lower part (401) or a housing upper part (403), wherein the housing (501) comprises at least one hexagonal cutout (507-1) and one cylindrical cutout (507-2), and wherein the housing (501) comprises on one side a hexagonal cutout (507-1) for inserting a hexagonal portion of the sealing element (405) and on an opposite side a cylindrical cutout (507-2) for inserting a cylindrical portion of the sealing element (405).

2. Functional component upper part (500) according to claim 1, wherein the mechanical interface has screw connections located at the corners of the housing.

3. Functional component upper part (500) according to claim 1 or 2, wherein the housing (501) comprises a side opening (505) for the insertion of an electrical cable (515).

4. Functional component upper part (500) according to one of claims 1 to 3, wherein the housing (501) comprises an internal thread (509) for a cable gland.

5. Functional component upper part (500) according to one of claims 1 to 4, wherein the connection device (513) comprises at least one mantle terminal (517).

6. Functional component upper part (500) according to one of the preceding claims, wherein the functional component upper part (500) comprises or forms a cover with a closable opening.

7. Functional component upper part (500) according to one of the preceding claims, wherein the functional component upper part (500) comprises cooling fins for dissipating heat.

8. Functional component upper part (500) according to one of the preceding claims, wherein the functional component upper part (500) is formed of a metal material, of plastic, or of a composite material.

9. Functional component upper part (500) according to one of the preceding claims, wherein the functional component upper part (500) comprises a switch for interrupting an electrical cable or a power supply or a frequency converter or a display.

10. Functional component upper part (500) according to one of the claims, wherein the functional component upper part (500) comprises a socket for connecting an electrical cable or a switch opening for an electrical connection.

11. Functional component upper part (500) according to one of the claims, wherein the functional component upper part (500) comprises a further mechanical interface, onto which a functional upper part of a further functional component can be placed.

## Revendications

1. Partie supérieure (403, 500) de composant fonctionnel destinée à être mise en place sur une partie inférieure (401) d'un composant fonctionnel (400) d'un système de montage de composants (100), comprenant
un boîtier (501) ;
une interface mécanique formée dans le boîtier (501) pour un raccordement mécanique avec la partie inférieure (401) de composant fonctionnel ; et
des prises pour le logement des fiches de la partie inférieure de composant fonctionnel (401), disposées sur une face inférieure du boîtier (501) de la partie supérieure de composant fonctionnel (500),
où ladite partie supérieure (500) de composant fonctionnel comprend un dispositif de connexion (513), en particulier un bloc de bornes pour la connexion d'une ligne électrique (515) insérée, et
**caractérisée en ce que**
le boîtier (501) comprend un contour d'étanchéité périphérique (503) pour un élément d'étanchéité (405), permettant d'assurer l'étanchéité de la partie supérieure (500) de composant fonctionnel par rapport à la partie inférieure (401) de composant fonctionnel ou une partie supérieure (403) de boîtier, le boîtier (501) comprenant au moins un évidement hexagonal (507-1) et un évidement cylindrique (507-2), et le boîtier (501) comprenant sur un côté un évidement hexagonal (507-1) pour la mise en place d'une section hexagonale de l'élément d'étanchéité (405) et sur un côté opposé un évidement cylindrique (507-2) pour la mise en place d'une section cylindrique de l'élément d'étanchéité (405).

2. Partie supérieure (500) de composant fonctionnel selon la revendication 1, où l'interface mécanique présente des connexions à vis situées dans les coins du boîtier.

3. Partie supérieure (500) de composant fonctionnel selon la revendication 1 ou la revendication 2, où le boîtier (501) comporte une ouverture latérale (505) pour l'insertion d'une ligne électrique (515).

4. Partie supérieure (500) de composant fonctionnel selon l'une des revendications 1 à 3, où le boîtier (501) présente un filet intérieur (509) pour un presse-étoupe.

5. Partie supérieure (500) de composant fonctionnel selon l'une des revendications 1 à 4, où le dispositif de connexion (513) comprend au moins une borne à chemise (517).

6. Partie supérieure (500) de composant fonctionnel selon l'une des revendications précédentes, où ladite partie supérieure (500) de composant fonctionnel comprend ou forme un couvercle avec une ouverture refermable.

7. Partie supérieure (500) de composant fonctionnel selon l'une des revendications précédentes, où ladite partie supérieure (500) de composant fonctionnel présente des ailettes de refroidissement pour la dissipation de chaleur.

8. Partie supérieure (500) de composant fonctionnel selon l'une des revendications précédentes, où ladite partie supérieure (500) de composant fonctionnel est en matériau métallique, en matière plastique ou en matériau composite.

9. Partie supérieure (500) de composant fonctionnel selon l'une des revendications précédentes, où ladite partie supérieure (500) de composant fonctionnel comprend un interrupteur pour la coupure d'une ligne électrique, ou un bloc d'alimentation, ou un convertisseur de fréquence, ou un afficheur.

10. Partie supérieure (500) de composant fonctionnel selon l'une des revendications précédentes, où ladite partie supérieure (500) de composant fonctionnel comprend un connecteur femelle pour le raccordement d'une ligne électrique ou une traversée pour une connexion électrique.

11. Partie supérieure (500) de composant fonctionnel selon l'une des revendications précédentes, où ladite partie supérieure (500) de composant fonctionnel comprend une autre interface mécanique sur laquelle une partie supérieure d'un autre composant fonctionnel peut être mise en place.
